# EUROPÄISCHE PATENTSCHRIFT

(11) **EP 1 223 621 B1**
(45) Veröffentlichungstag und Bekanntmachung des Hinweises auf die Patenterteilung: **07.04.2010**
(21) Anmeldenummer: 01129956.7
(22) Anmeldetag: 17.12.2001
(51) Int. Cl.: H01L 21/8239, H01L 21/8247

(54) **Verfahren zur Herstellung von eingebetteten nichtflüchtigen Halbleiterspeicherzellen**
Method of manufacturing of embedded non-volatile semiconductor memory cells
Procédé de fabrication de cellules de mémoire semi-conductrice non-volatile encastrée

(30) Priorität: 12.01.2001 DE 10101270
(43) Veröffentlichungstag der Anmeldung: 17.07.2002
(73) Patentinhaber: Infineon Technologies AG, 81669 München (DE)
(72) Erfinder: Gehring, Oliver, 01187 Dresden (DE); Langheinrich, Wolfram, 01324 Dresden (DE)
(74) Vertreter: Kindermann, Peter

(56) Entgegenhaltungen:
- EP-A- 0 305 741
- DE-A1- 3 107 543
- US-A- 6 117 730
- US-A- 6 159 799

## Beschreibung

Die vorliegende Erfindung bezieht sich auf ein Verfahren zur Herstellung von eingebetteten nichtflüchtigen Halbleiterspeicherzellen und insbesondere auf ein Verfahren zur Herstellung von nichtflüchtigen Speicherzellen in einer Halbleiterschaltung mit zumindest einem Hochvoltbereich und einem Logikbereich.

Zur Herstellung von eingebetteten bzw. sogenannten nichtflüchtigen Halbleiterspeicherzellen in Halbleiterschaltungen, die beispielsweise einen Logikteil und einen Hochspannungsteil aufweisen, werden verschiedene Typen von Transistoren in den jeweiligen Schaltungsteilen bzw. Bereichen benötigt, um die unterschiedlichen, zum Teil gegensätzlichen Anforderungen zu erfüllen. Beispielsweise müssen Transistoren in einem nichtflüchtigen Speicherbereich eine Tunnelschicht, eine ladungsspeichernde Schicht, eine Koppelschicht und eine Steuerschicht aufweisen um sogenannte Ein- oder Mehrtransistorspeicherzellen zu realisieren. Demgegenüber bestehen Transistoren in einem Logikteil bzw. Logikbereich lediglich aus einer Gateoxidschicht und einer Steuerschicht, so dass zumindest im Logikbereich die ladungsspeichernde Schicht und die Koppelschicht wieder abgelöst werden müssen.

Insbesondere in einem Logikbereich ist eine derartige teilweise Ablösung der Koppelschicht problematisch, da sich Strukturen im Submikrometerbereich nicht mehr oder äußerst schwierig nasschemisch strukturieren lassen. Bei Verwendung von Trockenätzprozessen wird jedoch ein Einkristall eines verwendeten Substrats durch Einbau von Versetzungen und Fremdatomen in der kritischen obersten Schicht gestört, wodurch sich insbesondere bei der Ausbildung einer nachfolgenden Gateoxidschicht Probleme ergeben. Genauer gesagt führen diese Störstellen zu Schwachstellen in der Gateoxidschicht.

Insbesondere an die Zuverlässigkeit von Schichten im Logikbereich hinsichtlich einer Durchbruchsfestigkeit werden jedoch höchste Anforderungen gestellt, da sie die elektrischen Eigenschaften der Halbleiterschaltung maßgeblich beeinflussen.

Aus der Druckschrift US 6,159,799 A ist ein Verfahren zur Herstellung von eingebetteten nichtflüchtigen Halbleiterspeicherzellen bekannt, wobei eine erste Gateoxidschicht auf einem Substrat in einem Hochvoltbereich, einem Speicherbereich und einem Logikbereich ganzflächig ausgebildet wird und anschließend im Speicherbereich entfernt wird. Daraufhin wird eine Tunneloxidschicht ganzflächig ausgebildet. Im Speicherbereich wird darauf eine ladungsspeichernde Schicht mit einer ONO-Schicht aufgebracht und strukturiert. Anschließend werden im Logikbereich die ONO-Schicht sowie die ladungsspeichernde Schicht entfernt und die erste Gateoxidschicht teilweise zurückgeätzt. Auf der rückgeätzten ersten Gateoxidschicht werden daraufhin eine zweite Gateoxidschicht und darauf eine leitende Steuerschicht ausgebildet und strukturiert.

Die Druckschrift EP 0 305 741 A2 offenbart ferner eine Halbleitervorrichtung mit einem Speicherbereich und einem Logikbereich, wobei im Logikbereich jeweilige Isolierschichten vollständig entfernt werden.

Aus der Druckschrift US 6,117,730 A ist ein Verfahren zur Herstellung einer nichtflüchtigen Halbleiterspeicherzelle bekannt, wobei die Verwendung von ONO-Schichtenfolgen insbesondere für nicht leitende ladungsspeichernde Schichten gezeigt ist.

Der Erfindung liegt daher die Aufgabe zu Grunde ein Verfahren zur Herstellung von eingebetteten nichtflüchtigen Halbleiterspeicherzellen zu schaffen, mit dem eine Zuverlässigkeit einer Schaltung zumindest in einem Logikbereich verbessert ist.

Erfindungsgemäß wird diese Aufgabe durch die Maßnahmen des Patentanspruchs 1 gelöst.

Insbesondere durch das Entfernen der dritten Isolierschicht und der ladungsspeichernden Schicht mittels eines Trockenätzverfahrens und das Entfernen der ersten und zweiten Isolierschicht mit einem nasschemischen Ätzverfahren, kann im Logikbereich auf einfache und kostengünstige Art und Weise eine hochwertige Substratoberfläche freigelegt werden kann.

Vorzugsweise wird hierbei zunächst die ladungsspeichernde Schicht strukturiert und anschließend die dritte Isolierschicht ganzflächig darauf ausgebildet, wodurch sich eine verbesserte Seitenwandisolierung für die ladungsspeichernden Schichtelemente ergibt und die Ladungshaltezeiten verbessert werden können.

Vorzugsweise besteht die erste Isolierschicht aus einer 20 bis 25 nm dicken Oxidschicht, auf der eine ca. 7 bis 10 nm dicke Tünneloxidschicht thermisch ausgebildet wird. Die erste und zweite Isolierschicht ergeben hierbei gemeinsam eine Hochvoltoxidschicht für die in einem Hochvoltbereich liegenden Schaltelemente bzw. Transistoren.

Die ladungsspeichernde Schicht besteht aus einer elektrisch leitenden oder einer elektrisch nicht leitenden Schicht, wodurch sich unterschiedliche Typen von nichtflüchtigen Halbleiterspeicherzellen realisieren lassen.

Vorzugsweise wird als dritte Isolierschicht eine ONO-Schichtenfolge ausgebildet, die hervorragende Koppeleigenschaften bei leichter Herstellbarkeit realisiert.

Als vierte Isolierschicht wird mit herkömmlichen Verfahren eine Gateoxidschicht entweder thermisch ausgebildet oder abgeschieden, wodurch man die für den Logikteil notwendige Zuverlässigkeit dieser Isolierschicht hinsichtlich Durchbruchsfestigkeit erhält.

In den weiteren Unteransprüchen sind weitere vorteilhafte Ausgestaltungen der Erfindung gekennzeichnet.

Die Erfindung wird nachstehend anhand von Ausführungsbeispielen unter Bezugnahem auf die Zeichnung näher beschrieben.

Es zeigen:
Figuren 1A bis 4B jeweilige Draufsichten und Schnittansichten einer Halbleiterschaltung zur Veranschaulichung von Herstellungsschritten gemäß einem ersten Ausführungsbeispiel;
Figuren 5A und 5B eine Draufsicht und eine Schnittansicht der Halbleiterschaltung zur Veranschaulichung von weiteren Herstellungsschritten gemäß dem ersten Ausführungsbeispiel;
Figuren 5C bis 5E jeweilige Schnittansichten entlang einer Schnittlinie C-C', D-D' und E-E' in Figur 5A.

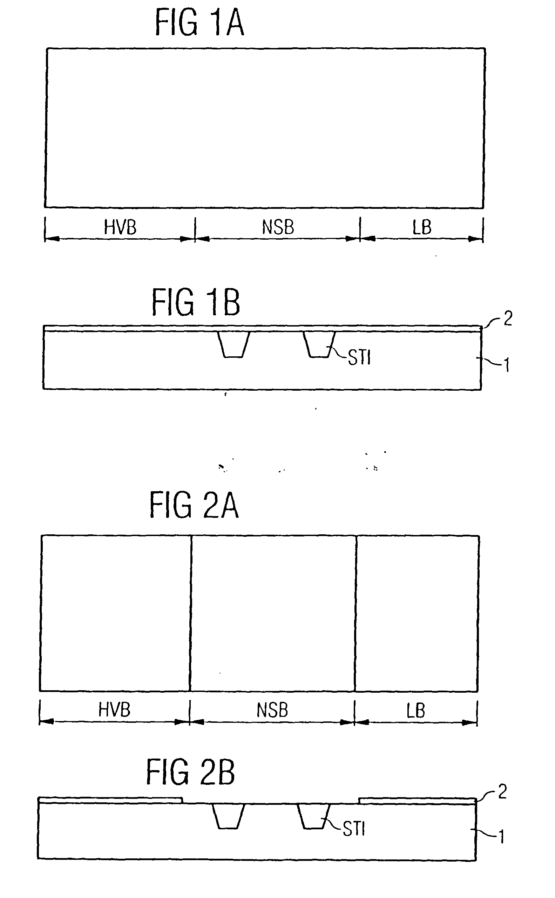

Figuren 1A und 1B zeigen eine jeweilige Draufsicht und eine Schnittansicht einer Halbleiterschaltung mit einem Hochspannungsbereich bzw. Hochvoltbereich HVB, einem nichtflüchtigen Speicherbereich NSB und einem Logikbereich LB. Gemäß der vorliegenden Erfindung sollen demzufolge nichtflüchtige Halbleiterspeicherzellen in dem nichtflüchtigen Speicherbereich NSB ausgebildet werden, wobei gleichzeitig in den weiteren Hochvolt- und Logikbereichen HVB und LB entsprechende Schaltelemente von Hochvolttransistoren und Logiktransistoren ausgebildet werden sollen. Da diese Schaltelemente wie eingangs bereits diskutiert wurde unterschiedliche und oftmals sogar gegensätzliche Anforderungen erfüllen müssen, wird nachfolgend eine besonders vorteilhafte Prozessierung insbesondere zur Realisierung von sogenannten eingebetteten bzw. embedded nichtflüchtigen Halbleiterspeicherzellen beschrieben. Die Erfindung bezieht sich hierbei im Wesentlichen auf das Ausbilden der ersten Schichten auf einem Substrat, weshalb auf die Prozessierung zum Ausbilden von aktiven Bereichen und verschieden dotierten Wannen im Substrat sowie auf das Ausbilden von "oberen" Schichtenfolgen nachfolgend nicht näher eingegangen wird.

Gemäß Figur 1B wird nach der Ausbildung von aktiven Bereichen durch beispielsweise eine flache Grabenisolierung (shallow trench isolation, STI) im nichtflüchtigen Speicherbereich NSB zunächst auf einem Substrat 1, welches beispielsweise ein Silizium-Halbleitersubstrat darstellt, eine erste Isolierschicht 2 ausgebildet. Die erste Isolierschicht 2 kann beispielsweise durch ein Abscheideverfahren ausgebildet werden und besteht vorzugsweise aus einer 20 bis 25 nm dicken Siliziumoxidschicht. Alternativ kann jedoch auch eine thermische Ausbildung stattfinden.

Gemäß Figur 2A und Figur 2B wird in einem nachfolgenden Herstellungsschritt die erste Isolierschicht 2 im nichtflüchtigen Speicherbereich NSB lokal entfernt. Diese Strukturierung wird beispielsweise mit einer nicht dargestellten lithografischen Maske durchgeführt, wobei unter Verwendung von nasschemischen oder trockenchemischen Prozessen ein Entfernen der ersten Isolierschicht 2 mit nachfolgendem Lackstrippen erfolgt. Auf die Ausbildung von eventuell notwendigen Wannen und sonstigen Dotiergebieten in den jeweiligen Bereichen der Halbleiterschaltung wir an dieser Stelle explizit verzichtet, da es sich hierbei um nicht erfindungswesentliche Schritte handelt.

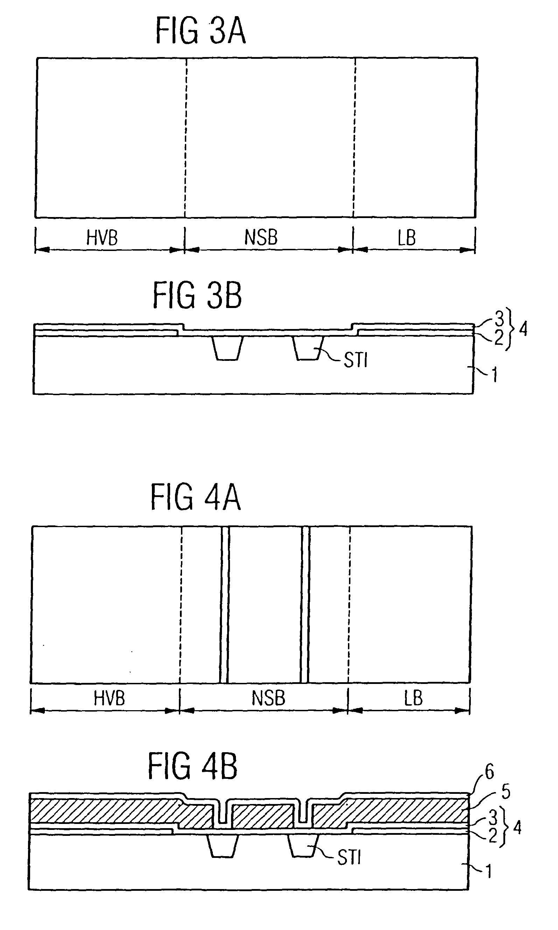

Gemäß Figuren 3A und 3B wird eine zweite Isolierschicht 3 ganzflächig ausgebildet. Beispielsweise wird diese zweite Isolierschicht 3 in einem Ofenprozess oder mittels eines RTP-Verfahrens (rapid thermal process) thermisch ausgebildet, wodurch sich vorzugsweise eine ca. 7 bis 10 nm dicke Tunneloxidschicht ausbildet. Diese Tunneloxidschicht wird im nichtflüchtigen Speicherbereich als Tunnelschicht für die jeweiligen nichtflüchtigen Halbleiterspeicherzellen verwendet, während sie insbesondere im Hochvoltbereich HVB gemeinsam mit der ersten Isolierschicht 2 eine Hochvoltoxidschicht 4 ausbildet, die ca. eine Dicke von 25 bis 35 nm aufweist. Die verringerte Dicke ergibt sich hierbei im Wesentlichen auf Grund des verringerten Oxidwachstums auf der ersten Isolierschicht 2.

In einem weiteren Herstellungsschritt gemäß Figuren 4A und 4B erfolgt nunmehr ein ganzflächiges Ausbilden und Strukturieren einer ladungsspeichernden Schicht 5 mit einer dritten Isolierschicht 6, wobei gemäß einem in Figur 4B dargestellten ersten Ausführungsbeispiel zunächst die ladungsspeichernde Schicht 5 ganzflächig beispielsweise als hochdotierte (insitu-) Polysiliziumschicht abgeschieden und anschließend in vertikaler Richtung beispielsweise oberhalb der Grabenisolierung STI strukturiert wird. In einem nachfolgenden Schritt wird die dritte Isolierschicht 6 ganzflächig ausgebildet, die beispielsweise aus einer ONO-Schichtenfolge (Oxid/Nitrid /Oxid) bestehen kann. Die dritte Isolierschicht 6 dient insbesondere im nichtflüchtigen Speicherbereich NSB als Koppelschicht und wird auch als Koppeloxidschicht bezeichnet. Insbesondere auf Grund der ausschließlichen Strukturierung der ladungsspeichernden Schicht 5 mit nachfolgender Ausbildung der dritten Isolierschicht 6 können die Seitenwände der streifenförmig ausgebildeten ladungsspeichernden Schichten 5 besonders gut isoliert werden, was sich für die Ladungshaltefähigkeit von Speicherzellen in günstiger Weise auswirkt.

Alternativ zur vorstehend beschriebenen leitenden ladungsspeichernden Schicht 5 kann in gleicher Weise auch eine nicht leitende ladungsspeichernde Schicht verwendet werden, wodurch sich die Ladungshalteeigenschaften von nichtflüchtigen Halbleiterspeicherzellen weiter verbessern lassen.

In gleicher Weise kann an Stelle der ONO-Schichtenfolge für die dritte Isolierschicht 6 ein anderes Dielektrikum als Koppelschicht verwendet werden, wobei insbesondere Schichten mit hoher relativer Dielektrizitätskonstante eine Reduzierung von Schreib/Lesespannungen in dem nichtflüchtigen Speicherbereich NSB begünstigen. Ein Programmieren erfolgt hierbei vorzugsweise über Fowler-Nordheim-Tunneln oder Injektion heißer Ladungsträger durch die zweite Isolierschicht 3 bzw. Tunneloxidschicht.

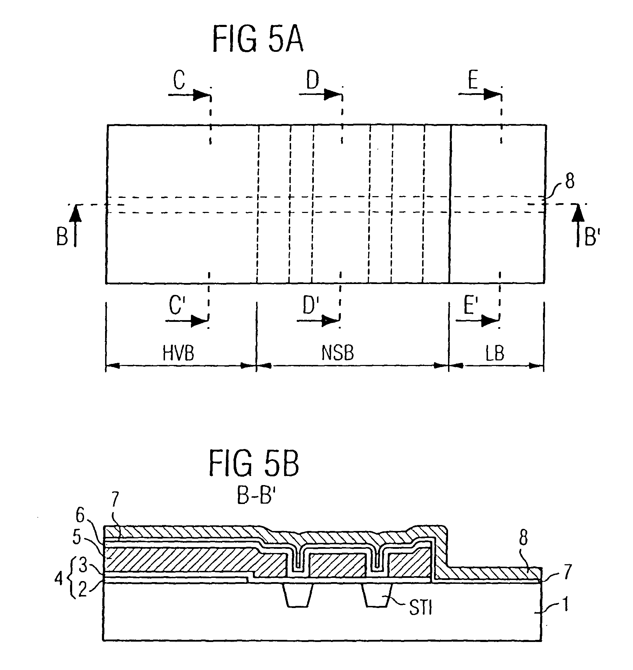

In einem weiteren Herstellungsschritt gemäß Figuren 5A und 5B wird nunmehr lokal die erste bis dritte Isolierschicht 2, 3 und 6 sowie die ladungsspeichernde Schicht 5 im Logikbereich LB entfernt. Vorzugsweise wird hierbei zunächst ein trockenchemisches Ätzen der dritten Isolierschicht 6 und der ladungsspeichernden Schicht 5 durchgeführt, die beispielsweise auch gemeinsam bzw. gleichzeitig mit der Strukturierung der ladungsspeichernden Schicht 5 und/oder der dritten Isolierschicht 6 im nichtflüchtigen Speicherteil NSB gemäß Figuren 4A und 4B erfolgen kann. Alternativ kann jedoch auch ein nasschemisches Ätzen des Logikbereichs LB durchgeführt werden.

Anschließend wird beispielsweise unter Verwendung eines nasschemischen Ätzvorgangs das aus der ersten und zweiten Isolierschicht 2, 3 bestehende Hochvoltoxid 4 im Logikbereich entfernt, wobei vorzugsweise gepufferte oder verdünnte Flusssäure (HF) verwendet wird. Auf diese Weise werden großflächig und auf relativ schonende Weise die vorher aufgebrachten Schichten bis zur Oberfläche des Substrats 1 entfernt, wobei man eine sehr gute Substratoberfläche ohne Versetzungen und Fremdatome erhält.

Auf Grund dieser sehr guten Substratoberfläche mit einer sehr geringen Anzahl von Störstellen kann in einem nachfolgenden Prozessschritt eine vierte Isolierschicht 7 ganzflächig ausgebildet werden, die insbesondere im Logikbereich die hinsichtlich Durchbruchsfestigkeit geforderten hohen Ansprüche hinsichtlich Zuverlässigkeit voll erfüllt. Beispielsweise wird diese vierte Isolierschicht 7 als Gateoxidschicht (SiO₂) mittels eines Ofenprozesses oder RTP-Verfahrens thermisch ausgebildet. Sie kann jedoch auch aus der Gasphase abgeschieden werden.

In einem nachfolgenden Herstellungsschritt wird abschließend eine leitende Steuerschicht 8 ausgebildet, wobei beispielsweise eine elektrisch leitende Polysiliziumschicht abgeschieden und mittels beispielsweise einer TEOS-Hartmaske strukturiert wird. Alternativ kann jedoch auch undotiertes Polysilizium abgeschieden und nachfolgend implantiert oder eine metallische Schicht als Steuerschicht 8 abgeschieden werden. Vorzugsweise wird bei der Strukturierung dieser Steuerschicht 8 im nichtflüchtigen Speicherbereich NSB gleichzeitig auch die Koppelschicht bzw. die dritte Isolierschicht 6 sowie die ladungsspeichernde Schicht 5 strukturiert, wodurch sich inselförmige ladungsspeichernde Schichtbereiche bzw. nichtflüchtige Halbleiterspeicherzellen ergeben. In gleicher Weise können auch im Hochvoltbereich HVB entsprechende Schalttransistoren ausgebildet werden.

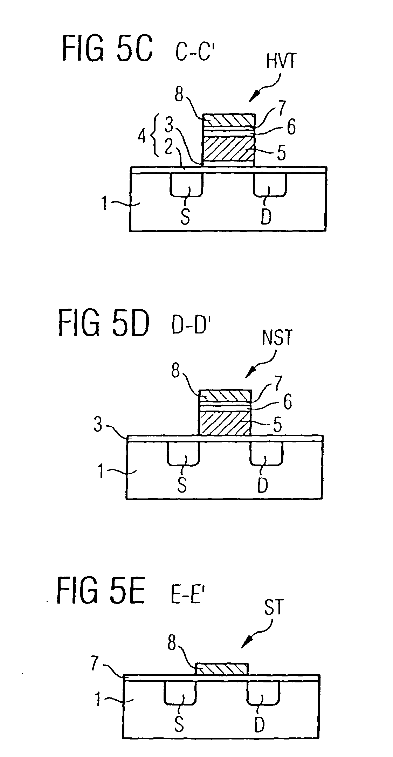

Figur 5C zeigt eine vereinfachte Schnittansicht gemäß eines Schnitts C-C' von Figur 5A in einem Hochvoltbereich, wobei ein Hochvolttransistor HVT nunmehr einen Stapel aus einer Steuerschicht 8, einer vierten und dritten Isolierschicht 7 und 6, einer ladungsspeichernden Schicht 5 und einer Hochvoltoxidschicht 4 besteht. Vorzugsweise kann die ladungsspeichernde Schicht 5 in einem vorhergehenden Schritt entfernt oder mit der Steuerschicht 8 kurzgeschlossen werden. Die Sourcegebiete S und Draingebiete D können beispielsweise zu diesem Zeitpunkt selbstjustierend im Substrat 1 ausgebildet werden. Sie können jedoch auch zu einem späteren oder früheren Zeitpunkt durch verschiedene Verfahren ausgebildet werden.

Figur 5D zeigt eine Schnittansicht gemäß eines Schnitts D-D' in Figur 5A, wobei ein nichtflüchtiger Speichertransistor NST wiederum aus einer Steuerschicht 8, einer dritten und vierten Isolierschicht 6 und 7, einer ladungsspeichernden Schicht 5 und einer Tunneloxidschicht bzw. zweiten Isolierschicht 3 besteht. Wiederum können entsprechende Sourcegebiete S und Draingebiete D selbstjustierend mittels beispielsweise Ionenimplantation im Substrat 1 ausgebildet werden.

Figur 5E zeigt eine vereinfachte Schnittansicht entlang eines Schnitts E-E' gemäß Figur 5A in dem Logikbereich LB, wobei ein Schalttransistor ST lediglich eine Steuerschicht 8 und eine äußerst hochwertige Gateoxidschicht als vierte Isolierschicht 7 aufweist.

Demzufolge sind mit dem vorstehend beschriebenen Herstellungsverfahren insbesondere eingebettete nichtflüchtige Halbleiterspeicherzellen bzw. -transistoren NST in einem nichtflüchtigen Speicherbereich NSB auf einfache und kostengünstige Weise herzustellen, wobei gleichzeitig insbesondere die elektrischen Eigenschaften von Schalttransistoren ST in entsprechenden Logikbereichen LB nicht beeinträchtigt werden. Die für die jeweiligen charakteristischen Eigenschaften notwendigen Isolierschichten, die unmittelbar auf dem Substrat 1 liegen, können somit auf einfache und kostengünstige Weise mit hoher Qualität in einem gleichen Verfahren hergestellt werden.

Die Erfindung wurde vorstehend anhand von Silizium-Halbleitersubstraten beschrieben. Sie ist jedoch nicht darauf beschränkt und umfasst in gleicher Weise alternative Substratmaterialien. In gleicher Weise ist die Erfindung nicht auf die beschriebenen Siliziumdioxid-, Polysilizium- und ONO-Schichten beschränkt sondern umfasst in gleicher Weise alternative Materialien.

## Patentansprüche

1. Verfahren zur Herstellung von eingebetteten nichtflüchtigen Halbleiterspeicherzellen mit den Schritten:
a) Ausbilden einer ersten Isolierschicht (2) auf einem Substrat (1) in einem Hochvoltbereich (HVB), einem Speicherbereich (NSB) und einem Logikbereich (LB);
b) Entfernen der ersten Isolierschicht (2) im Speicherbereich (NSB);
c) Ausbilden einer zweiten Isolierschicht (3) im Hochvoltbereich (HVB), Speicherbereich (NSB) und Logikbereich (LB);
d) Ganzflächiges Ausbilden und Strukturieren einer Ladungsspeichernden Schicht (5) und darauf ganzflächiges Ausbilden einer dritten Isolierschicht (6);
e) Entfernen der ersten bis dritten Isolierschicht (2, 3, 6) sowie der ladungsspeichernden Schicht (5) im Logikbereich (LB), wobei die dritte Isolierschicht (6) und die ladungsspeichernde Schicht (5) mittels Trockenätzen und die erste und zweite Isolierschicht (2, 3) mittels nasschemisches Ätzen entfernt wird;
f) Ausbilden einer vierten Isolierschicht (7) im Hochvoltbereich (HVB), Speicherbereich (NSB) und Logikbereich (LB); und
g) Ausbilden und Strukturieren einer leitenden Steuerschicht (8) auf der vierten Isolierschicht (7).

2. Verfahren nach Patentanspruch 1,
**dadurch gekennzeichnet, dass** in Schritt d) nur die ladungsspeichernde Schicht (5) strukturiert wird und die dritte Isolierschicht (6) ganzflächig darauf ausgebildet wird.

3. Verfahren nach einem der Patentansprüche 1 oder 2,
**dadurch gekennzeichnet, dass** in Schritt a) eine 20 bis 25 nm dicke Oxidschicht abgeschieden wird.

4. Verfahren nach einem der Patentansprüche 1 bis 3,
**dadurch gekennzeichnet, dass** in Schritt c) eine ca. 7 bis 10 nm dicke Tunneloxidschicht thermisch ausgebildet wird.

5. Verfahren nach einem der Patentansprüche 1 bis 4,
**dadurch gekennzeichnet, dass** die erste und zweite Isolierschicht (2, 3) eine Hochvoltoxidschicht (4) ausbilden.

6. Verfahren nach einem der Patentansprüche 1 bis 5,
**dadurch gekennzeichnet, dass** in Schritt d) eine elektrisch leitende oder nicht leitende Schicht als ladungsspeichernde Schicht (5) ausgebildet wird.

7. Verfahren nach einem der Patentansprüche 1 bis 6,
**dadurch gekennzeichnet, dass** in Schritt d) eine ONO-Schichtenfolge als dritte Isolierschicht (6) ausgebildet wird.

8. Verfahren nach einem der Patentansprüche 1 bis 7,
**dadurch gekennzeichnet, dass** in Schritt f) eine Gateoxidschicht als vierte Isolierschicht (7) thermisch ausgebildet oder abgeschieden wird.

9. Verfahren nach einem der Patentansprüche 1 bis 8,
**dadurch gekennzeichnet, dass** das Strukturieren in Schritt g) mittels einer Hartmaske erfolgt.

## Claims

1. Method for fabricating embedded nonvolatile semiconductor memory cells having the steps of:
a) forming a first insulating layer (2) on a substrate (1) in a high-voltage region (HVB), a memory region (NSB) and a logic region (LB);
b) removing the first insulating layer (2) in the memory region (NSB);
c) forming a second insulating layer (3) in the high-voltage region (HVB), memory region (NSB) and logic region (LB);
d) forming in a whole-area manner and patterning a charge-storing layer (5) and forming a third insulating layer (6) in a whole-area manner thereon;
e) removing the first to third insulating layers (2, 3, 6) and also the charge-storing layer (5) in the logic region (LB), the third insulating layer (6) and the charge-storing layer (5) being removed by means of dry etching and the first and second insulating layers (2, 3) being removed by means of wet-chemical etching;
f) forming a fourth insulating layer (7) in the high-voltage region (HVB), memory region (NSB) and logic region (LB);
g) forming and patterning a conductive control layer (8) on the fourth insulating layer (7).

2. Method according to Patent Claim 1,
**characterized in that**, in step d), only the charge-storing layer (5) is patterned and the third insulating layer (6) is formed in a whole-area manner thereon.

3. Method according to either of Patent Claims 1 and 2,
**characterized in that**, in step a), an oxide layer having a thickness of 20 to 25 nm is deposited.

4. Method according to one of Patent Claims 1 to 3,
**characterized in that**, in step c) a tunnel oxide layer having a thickness of approximately 7 to 10 nm is formed thermally.

5. Method according to one of Patent Claims 1 to 4,
**characterized in that** the first and second insulating layers (2, 3) form a high-voltage oxide layer (4).

6. Method according to one of Patent Claims 1 to 5,
**characterized in that**, in step d), an electrically conductive or nonconductive layer is formed as the charge-storing layer (5).

7. Method according to one of Patent Claims 1 to 6,
**characterized in that**, in step d), an ONO layer sequence is formed as the third insulating layer (6) .

8. Method according to one of Patent Claims 1 to 7,
**characterized in that**, in step f), a gate oxide layer is deposited or formed thermally as the fourth insulating layer (7).

9. Method according to one of Patent Claims 1 to 8,
**characterized in that**, the patterning in step g) is effected using a hard mask.

## Revendications

1. Procédé de fabrication de cellules de mémoire à semiconducteur non volatile, encastrée, comprenant les stades dans lesquels :
a) on forme une première couche (2) isolante sur un substrat (1) dans une partie (HVB) de haute tension, dans une partie (NSB) de mémoire et dans une partie (LB) logique ;
b) on élimine la première couche (2) isolante dans la partie (NSB) de mémoire ;
c) on forme une deuxième couche (3) isolante dans la partie (HVB) de haute tension, dans la partie (NSB) de mémoire et dans la partie (LB) logique ;
d) on forme sur toute la surface et on structure une couche (5) d'accumulation de charges et on forme dessus sur toute la surface une troisième couche (6) isolante ;
e) on élimine les première à troisième couches (2, 3, 6) isolantes ainsi que la couche (5) d'accumulation de charges dans la partie (LB) logique, la troisième couche (6) isolante et la couche (5) d'accumulation de charges étant éliminées au moyen d'une attaque à sec et la première et la deuxième couches (2, 3) isolantes au moyen d'une attaque chimique en voie humide ;
f) on forme une quatrième couche (7) isolante dans la partie (HVB) de haute tension, dans la partie (NSB) de mémoire et dans la partie (LB) logique ; et
g) on forme et on structure une couche (8) de commande conductrice sur la quatrième couche (7) isolante.

2. Procédé suivant la revendication 1,
**caractérisé en ce que**, dans le stade d), on ne structure que la couche (5) d'accumulation de charges et on forme dessus sur toute la surface la troisième couche (6) isolante.

3. Procédé suivant l'une des revendications 1 ou 2,
**caractérisé en ce que**, dans le stade a), on dépose une couche d'oxyde d'une épaisseur de 20 à 25 nm.

4. Procédé suivant l'une des revendications 1 à 3,
**caractérisé en ce que**, dans le stade c), on forme thermiquement une couche d'oxyde tunnel d'une épaisseur de 7 à 10 nm environ.

5. Procédé suivant l'une des revendications 1 à 4,
**caractérisé en ce que** la première et la deuxième couche (2, 3) isolantes forment une couche (4) d'oxyde de haute tension.

6. Procédé suivant l'une des revendications 1 à 5,
**caractérisé en ce que**, dans le stade d), on forme une couche conductrice de l'électricité ou non conductrice comme couche (5) d'accumulation de charges.

7. Procédé suivant l'une des revendications 1 à 6,
**caractérisé en ce que**, dans le stade d), on forme une succession de couches ONO comme troisième couche (6) isolante.

8. Procédé suivant l'une des revendications 1 à 7,
**caractérisé en ce que**, dans le stade f), on forme thermiquement ou on dépose une couche d'oxyde de grille comme quatrième couche (7) isolante.

9. Procédé suivant l'une des revendications 1 à 8,
**caractérisé en ce qu'**on effectue la structuration dans le stade g) au moyen d'un masque dur.
